# EUROPÄISCHE PATENTSCHRIFT

(11) **EP 3 154 115 B1**
(45) Veröffentlichungstag und Bekanntmachung des Hinweises auf die Patenterteilung: **15.12.2021**
(21) Anmeldenummer: 15189075.3
(22) Anmeldetag: 09.10.2015
(51) Int. Cl.: H01M 10/42, H01M 10/48, G01R 31/392, G01R 15/20, G01R 15/18

(54) **FEHLERDETEKTION BEI BATTERIEZELLEN**
BATTERY CELL FAULT DETECTION
DÉTECTION D'ERREUR DANS DES CELLULES DE BATTERIE

(43) Veröffentlichungstag der Anmeldung: 12.04.2017
(73) Patentinhaber: Robert Bosch GmbH, 70442 Stuttgart (DE)
(72) Erfinder: Friedrich, Marco, 71638 Ludwigsburg (DE)
(74) Vertreter: Bee, Joachim

(56) Entgegenhaltungen:
- WO-A1-2015/104196
- JP-A- 2011 024 303
- US-A1- 2006 232 263
- US-A1- 2013 113 495
- None

## Beschreibung

Die vorliegende Erfindung betrifft eine Batteriezelle nach dem Oberbegriff des Anspruches 1. Zudem betrifft die Erfindung eine Batterie nach Anspruch 8 für Elektromobilitätsanwendungen und/oder Anwendungen in stationärer Energieversorgung, mit einer Batteriezelle nach einem der vorhergehenden Ansprüche.

### Stand der Technik

Bekannte Batterien für Anwendungen in der Elektromobilität, z. B. in Personenkraftwagen, Lastkraftwagen und im Allgemeinen in Kraftfahrzeugen mit einem vollelektrischen Antrieb oder mit einem elektrisch unterstützten Antrieb, weisen üblicherweise eine Reihenschaltung mehrerer Batteriezellen auf. Die Batteriezellen werden dabei üblicherweise in Modulen zusammengefasst, welche mit einer Sensorik zur Zellüberwachung versehen sein können. Mehrere Module bilden zusammen eine Batterie. Herkömmliche Batterien können mit einer zentralen Steuereinheit ausgebildet sein, die Signale von Sensoriken verschiedener Module empfangen und einfache Steueraktionen ausführen kann, wie z. B. das vollständige Abschalten der Batterie im Fehlerfall. Batteriezellen in solchen Batterien sind meistens elektrochemische Batteriezellen, oft sogar Hochleistungs- bzw. Hochenergie-Batteriezellen. Derzeitig werden üblicherweise Li-lonen-Batteriezellen für die benannten Anwendungen verwendet. Die Batteriezellen werden dabei in spezieller Bauform gefasst, wobei in einer üblichen Ausführungsform die Batteriezelle in einem prismatischen Gehäuse aus Aluminiumlegierungen oder Edelstahl angeordnet wird.

Ähnliche Batteriesysteme finden auch in anderen Gebieten Anwendung, beispielsweise in der Energieversorgung als stationäre Energiespeicher oder in Photovoltaikanlagen. Die im Folgenden geschilderten technischen Herausforderungen treten auch in diesen Gebieten auf, die offenbarte Erfindung kann auch in diesen Gebieten Anwendung finden.

Elektrochemische Batteriezellen bestehen üblicherweise aus einer flächigen Anordnung mehrerer Lagen von Trägermaterialien und chemischen Substanzen, welche durch elektrochemische Reaktionen eine elektrische Energiequelle erzeugen. In einer üblichen Realisierung einer Batteriezelle für die oben genannten Anwendungen werden diese unterschiedlichen Materialien in flachen Strukturen übereinander platziert und anschließend in kompakte geometrische Formen gebracht, z. B. durch Aufwickeln in runde oder flache Wickel (en: "jelly roll") oder Stapel in sogenannte Zellstapel. Batteriezellen aus flachen Wickeln oder Stapeln werden als prismatische Batteriezellen bezeichnet. Ein Wickel oder ein Zellstapel bildet dabei jeweils ein Batteriezellenelement. Prismatische Batteriezellen bestehen üblicherweise aus einem oder mehrerer solcher Batteriezellenelemente, welche an sich individuelle Energiequellen darstellen. In derzeit üblichen Realisierungen der Batteriezellen erfolgt die elektrische Kontaktierung zwischen den Batteriezellenelementen über sogenannte Zellterminals und der Spannungsabgriff erfolgt über einen gemeinsamen Stromkollektor an der Außenseite der Batteriezelle.

In Batteriezellen können beim Auftreten von Zellfehlern einzelner Batteriezellenelemente unerwünschte, potenziell gefährliche Reaktionen folgen. Dabei spricht man von einem Fehlerfall der Batteriezelle. Ein Beispiel für einen solchen Fehlerfall ist ein metallischer Partikel, welcher den Separator des Wickels durchdringt (ein sogenannter Kurzschluss der Batteriezelle). Ein weiteres Beispiel ist ein Körperschluss zwischen einem Wickel oder einem Stapel und elektrisch leitfähigem Zellgehäuse, was bei potenzialbehaftetem Zellgehäuse zu einem veränderten Stromverhältnis führen kann. Im Fehlerfall kann es zu starker Erwärmung einer einzelnen Batteriezelle oder mehrerer Batteriezellen in einem Modul kommen. Beim Überschreiten einer kritischen Zelltemperatur kann eine selbsterhaltende exotherme Reaktion in der Batteriezelle (thermal runaway) ausgelöst werden. Als Folge kann es sogar zum Zellbrand und zur Zellexplosion kommen.

Elektrochemische Batteriezellen besitzen also ein gewisses Gefahrenpotenzial, wobei die Auswirkungen im Fehlerfall auf Personen, Sachwerte und die Umwelt gravierend sein können. Die möglichen Gefährdungen durch elektrochemische Batteriezellen sind eine Herausforderung insbesondere bei Batteriezellen für die oben genannten Anwendungsfälle von Batteriezellen. Batteriezellen in solchen Anwendungen müssen oft eine hohe Leistung und hohe gespeicherte Energie bereitstellen und haben dadurch bedingt ein hohes Gefährdungspotenzial. Gleichzeitig bestehen jedoch hohe Anforderungen an die Sicherheit der Batteriezellen. Insbesondere für Hochleistungs- und Hochenergie-Batteriezellen und -Batterien der oben genannten Anwendungsfälle ist es erforderlich, auftretende Zellfehler möglichst früh und mit hoher Zuverlässigkeit zu erkennen, um gefährliche Situationen durch Warnung des Benutzers und/oder technische Gegenmaßnahmen zu vermeiden.

Es sind Verfahren bekannt, die basierend auf einer Veränderung von Strömen eine Fehlerdetektion ermöglichen, indem Messwerte dieser Ströme durch eine Auswerteelektronik ausgewertet werden. Die US 2013/0113495 A1 beschreibt eine solche Fehlerdetektion.

Die WO 2015/104196 A1 zeigt ein Batteriepack mit mehreren elektrochemischen Batteriezellen mit einer Vorrichtung zum Messen einer Differenz zwischen zwei Zellströmen zweier verschiedener Batteriezellen.

Die JP 2011 024303 A offenbart eine Ladesteuervorrichtung für einen wiederaufladbaren elektrischen Energiespeicher.

Die US 2006/232263 A1 zeigt eine Stromsensoranordnung.

### Offenbarung der Erfindung

Die voranstehende Aufgabe wird durch eine Batteriezelle mit den Merkmalen des Anspruches 1, durch eine Batterie mit den Merkmalen des Anspruches 8 und durch ein entsprechendes Kraftfahrzeug gelöst. Weitere Vorteile, Merkmale und Details der Erfindung ergeben sich aus den Unteransprüchen, der Beschreibung und den Zeichnungen. Dabei gelten Merkmale und Details, die im Zusammenhang mit der Batteriezelle beschrieben sind, selbstverständlich auch im Zusammenhang mit der erfindungsgemäßen Batterie und jeweils umgekehrt, sodass bezüglich der Offenbarung zu den einzelnen Erfindungsaspekten stets wechselseitig Bezug genommen wird, bzw. werden kann.

Die Erfindung stellt eine Batteriezelle, insbesondere für die oben genannten Anwendungsfälle bereit, wobei die Batteriezelle mit mindestens einem ersten Batteriezellenelement und einem zweiten Batteriezellenelement, welche über mindestens einen Stromkollektor elektrisch miteinander verbunden sind, und einem Sensor zum Überwachen mindestens eines Parameters der Batteriezelle ausgeführt ist. Hierzu ist es erfindungsgemäß vorgesehen, dass der Sensor derart ausgebildet ist, dass im Fehlerfall der Batteriezelle der Sensor, und insbesondere nur dann, eine detektierbare Veränderung eines Ausgangssignals generiert. Durch die Erfindung ist es möglich, eine zuverlässige, frühzeitige Erkennung von Zellfehlern zu erzielen und hierbei insbesondere mit einfachen Mitteln auszukommen. Erfindungsgemäß kann die Batteriezelle ebenfalls als "Zelle" bezeichnet werden, was sowohl einen Primär- als auch einen Sekundenenergiespeicher bedeuten kann und somit sowohl nicht wiederaufladbare Batteriezellen als auch den Begriff "Akkumulator" (im Sinne einer wiederaufladbaren Batteriezelle) mit einschließen kann. Unter einem Batteriezellenelement kann dabei sowohl ein Wickel als auch ein Stapel als auch andere Ausführungsformen der Aktivmaterialienschichtung verstanden werden. Die Batteriezelle ist unter anderem für Hochleistungs- bzw. Hochenergie-Batterien besonders gut geeignet. Unter den "Elektromobilitätsanwendungen" sind dabei Anwendungen von Batteriezellen in Personenkraftwagen, Lastkraftwagen und im Allgemeinen in Kraftfahrzeugen mit einem vollelektrischen Antrieb oder in Hybridfahrzeugen mit einem elektrisch unterstützten Antrieb gemeint. Unter dem Begriff "Parameter" wird zumindest jeder technische Parameter, ob physikalisch oder chemisch oder dergleichen verstanden, wie z. B.: Temperatur, Strom, Druck, Magnetfeld etc.

Die Erfindung stellt dabei eine Batteriezelle bereit, die eine einfache zellintegrierte Sensorik aufweist, mit derer Hilfe Zellfehler, insbesondere die zu elektrischen Fehlern führen, zuverlässig und ohne Zeitverlust erkannt werden können. Der Erfindungsgedanke liegt dabei darin, dass im Fehlerfall der Batteriezelle der Sensor direkt eine detektierbare Veränderung des Ausgangssignals generieren kann. Vorteilhaft ist dabei, dass die erfindungsgemäße Batteriezelle keine speziellen Anforderungen an den Aufbau eines Batteriesystems, wie eine Parallelschaltung gleichartiger Batteriezellen, erfüllen muss. Vorteilhaft ist auch, dass gemäß der Erfindung keine Strommessung und keine nachfolgende aufwendige Auswertung einzelner Stromwerte durch eine komplizierte Auswerteelektronik notwendig sind. Vielmehr wird die Abweichung vom Normalverhalten im Fehlerfall der Batteriezelle direkt durch das Ausgangssignal des erfindungsgemäßen Sensors detektiert. Die negativen Auswirkungen auf Personen, Sachwerte und die Umwelt durch Kurz- und Körperschlüsse im Fehlerfall der Batteriezelle können somit rechtzeitig vor dem Eintreten eines kritischen Zustandes der fehlerhaften Batteriezelle gestoppt werden.

Erfindungsgemäß ist der Sensor derart ausgebildet, dass ausschließlich (und genau nur dann) im Fehlerfall der Batteriezelle der Sensor eine detektierbare Veränderung des Ausgangssignals generiert. Somit lässt sich die Fehlerdetektion aufwandsarm realisieren. Außerdem kann der erfindungsgemäße Sensor dabei nicht nur einfach, sondern auch auf unterschiedlichste Weise konstruiert werden sowie an verschiedenen Stellen in der Batteriezelle eingesetzt werden. Vorteilhafterweise sind dabei keine nachteiligen Modifikationen der hochstromführenden Teile der Batteriezelle erforderlich, wie z. B. Einbringen von Shuntstrukturen zur Strommessung in Stromkollektoren, Einsetzen von komplizierten Auswertelektroniken in oder an Batteriezellen, oder das Anordnen der Batteriezellen in einer Parallelschaltung.

Gemäß der Erfindung kann die Batteriezelle als eine prismatische Batteriezelle, eine Rundzelle oder dergleichen ausgebildet sein. Der Vorteil einer prismatischen Batteriezelle ist, dass dabei mehrere Batteriezellenelemente oder mehrere Batteriezellen platzsparend nebeneinander angeordnet werden können und auf eine einfache Weise miteinander verschaltet werden können, um eine gewünschte Spannung und einen gewünschten Strom bereitzustellen. Aber auch auf Rundzellen lässt sich die Erfindung übertragen. Rundzellen können je nach Bauraum-Begebenheiten bzw. -Erfordernissen in Kraftfahrzeugen oder anderen Abnehmern von Vorteil sein. In allen Ausführungsformen kann das Batteriezellenelement als ein flaches oder ein rundes Batteriezellenelement, insbesondere ein Wickel (Jelly Roll) oder ein Stapel, ausgebildet sein, um eine entsprechende Batteriezelle zu bilden. Bei einem flachen Batteriezellenelement handelt es sich um eine Flachzelle.

Gemäß der Erfindung kann der Parameter der Batteriezelle, der durch den Sensor detektiert wird, das Magnetfeld zwischen den Batteriezellenelementen sein. Ein ungleichmäßiges Magnetfeld in der Batteriezelle, insbesondere zwischen den Wickeln oder Stapeln der Batteriezelle ist ein Anzeichen für einen Zellfehler, wie nachfolgend im Detail erklärt wird. Bei einer Anzahl N von parallel verschalteten Batteriezellenelementen (z. B. Jelly Rolls) teilt sich ein Lade- oder Entladestrom I durch die Batteriezelle in mehrere Einzelströme In, n=1,2,...N auf. Bei baugleichen Batteriezellenelementen mit ähnlichem Alterungs- und Ladezustand (dies wird im Normalfall innerhalb einer Batteriezelle näherungsweise angenommen) kann ungefähr von gleich großen Teilströmen ausgegangen werden, sofern kein Zellfehler vorliegt. Gleiche Teilströme in Batteriezellenelementen induzieren gleich starke aber gegensätzlich ausgerichtete Magnetfelder um die Batteriezellenelemente herum, die sich im Normalfall zwischen den Batteriezellenelementen kompensieren. Bei Auftreten eines internen Zellfehlers, z. B. eines Kurz- oder Körperschlusses, in einem Batteriezellenelement (Fehlerfall der Batteriezelle), welcher zu einem verringerten Innenwiderstand des Batteriezellenelementes führt, verteilt sich der durch die Batteriezelle fließende Gesamtstrom I ungleichmäßig I1>(I2,...,IN). Ungleiche Teilströme induzieren ein ungleichmäßiges magnetisches Feld zwischen den Batteriezellenelementen. Im Fehlerfall der Batteriezelle ist also ein Magnetfeld zwischen den Batteriezellenelementen messbar. Die Erfindung nutzt vorteilhafterweise diesen Effekt aus, um auf den Fehlerfall in der Batteriezelle zu schließen. Der Vorteil liegt dabei darin, dass eine Messung des Magnetfeldes mit einfachen Mitteln und insbesondere kontaktlos zu den Batteriezellenelementen realisiert werden kann. Ein weiterer Vorteil liegt dabei außerdem darin, dass die Messung des Magnetfeldes direkt zur Detektion des Zellfehlers dienen kann, ohne aufwendige Messung anderer Parameter der Batteriezelle, wie beispielsweise einzelner Stromwerte der Batteriezellenelemente, und ohne komplizierte Umrechnung dieser Stromwerte. Folglich kann der Sensor den Fehlerfall vorteilhafterweise als eine direkt detektierbare Veränderung des Ausgangssignals liefern. Hierbei kann der Sensor nur dann eine solche Veränderung des Ausgangssignals bereitstellen, wenn etwas nicht in Ordnung ist. Dabei kann der Sensor derart kalibriert werden, dass er im Normalfall, wenn ein gleichmäßiges Magnetfeld induziert wird, kein Signal ausgibt oder ein näherungsweise konstantes, bekanntes Signal ausgibt.

Hierbei kann der Sensor als ein Magnetfeldsensor, insbesondere als ein Hallsensor, ausgebildet sein. Mithin kann der Vorteil erreicht werden, dass der Sensor einfach ausgebildet sein kann und keinen elektrischen Kontakt zu Batteriezellenelementen benötigt. Ein weiterer Vorteil liegt dabei darin, dass der Magnetfeldsensor auf unterschiedliche Weise realisiert werden kann. Zudem kann der Magnetfeldsensor an verschiedenen Stellen in der Batteriezelle angeordnet werden, um das Magnetfeld zwischen den Batteriezellenelementen zu sensieren. Die erfindungsgemäße Batteriezelle kann somit nicht nur einfach, sondern auch flexibel ausgestaltet sein. Der Magnetfeldsensor ist vorteilhafterweise optimal geeignet, im Fehlerfall der Batteriezelle, und insbesondere ausschließlich dann, eine direkt detektierbare Veränderung des Ausgangssignals zu generieren. Erfindungsgemäß kann der Sensor ein Hallsensor sein. Der Hallsensor ist vorteilhafterweise ein einfacher elektrotechnischer Baustein, welcher ohne Permanentmagnete auskommt, und welcher zuverlässige, hochsensitive Messungen eines Magnetfeldes liefert. Deswegen kann die Erkennung des Fehlerfalls in der erfindungsgemäßen Batteriezelle besonders sensitiv sein, wobei schon geringe Abweichungen vom Normalfall zuverlässig erkannt werden. Dies macht die erfindungsgemäße Batteriezelle optimal geeignet für Elektromobilitätsanwendungen.

Alternativ kann vorgesehen sein, dass das erste Batteriezellenelement einen ersten Stromkollektor aufweisen kann und das zweite Batteriezellenelement einen zweiten Stromkollektor aufweisen kann, wobei der erste Stromkollektor mit dem zweiten Stromkollektor über einen gemeinsamen Stromkollektor elektrisch verbunden sein kann. Dabei kann der Sensor zwischen dem ersten Stromkollektor und dem zweiten Stromkollektor angeordnet sein. Hiermit ist vorteilhafterweise eine rein geometrische Anordnung gemeint und keine elektrische. Mit solcher Anordnung des Sensors lassen sich mehrere Vorteile der Erfindung erreicht werden, wie eine kontaktlose Anordnung des Sensors bezüglich der Batteriezellenelemente und eine Vereinfachung des Aufbaus der Batteriezelle, wobei mit dem Sensor zudem sogar herkömmliche Batteriezellen nachträglich aufgerüstet werden können. Hierzu kann der Sensor von außen zwischen den Stromkollektoren positioniert werden, ohne Eingriff in das Innere der Batteriezellenelemente. Denkbar ist es dabei, dass der Sensor am bzw. im Gehäuse der Batteriezelle befestigt werden kann, beispielsweise auf einer isolierenden Unterlage, um die Messung des Magnetfeldes durch das elektrisch leitfähige Gehäuse nicht zu stören.

Erfindungsgemäß weist die Batteriezelle mindestens ein Zellterminal auf, welches als ein elektrischer Kontakt der Batteriezelle dient, wobei der Sensor im Zellterminal integriert ist. Das Zellterminal kann dabei mit einer Elektrode elektrisch verbunden sein oder selbst eine Elektrode darstellen, um elektrische Energie an einen Verbraucher bereitzustellen oder zwecks Verbindung mit einer weiteren Batteriezelle. Mithin können ebenfalls die Vorteile der kontaktlosen Anordnung des Sensors bezüglich der Batteriezellenelemente sowie des einfachen Aufbaus der Batteriezelle realisiert werden. Außerdem ist es dabei vorteilhaft, dass dadurch keinerlei Umbauten an den Batteriezellenelementen erforderlich sind, wobei der Sensor sogar nachträglich in vorhandene Batteriezellen integriert werden kann. Hierzu kann nur das Zellterminal aufgerüstet werden, was in einer besonders vorteilhaften Ausführung von außen, ohne Eindringen ins Batterieinnere, erfolgen kann.

Alternativ ist es denkbar, dass der Sensor zwischen den Batteriezellenelementen angeordnet sein kann. Auch hier ist vorteilhafterweise eine rein geometrische Anordnung gemeint und keine elektrische. Vorteilhafterweise benötigt der Sensor dabei keine elektrische Verbindung zu Teilen der Batteriezelle. Der Sensor kann dabei völlig unabhängig vom Stromkreis der Batteriezelle betrieben werden und kontaktlos zu den Batteriezellenelementen funktionieren. Somit kann der Aufbau der Batteriezelle vereinfacht werden.

Des Weiteren ist es gemäß der Erfindung denkbar, dass der Sensor in Form einer Spule, insbesondere einer Rogowskispule, ausgebildet sein kann. Ein Sensor in Form einer Spule kann einfach angelegt und entfernt werden, ohne den Stromkreis der Batteriezelle auftrennen zu müssen. Der Sensor kann somit vorteilhafterweise kontaktlos zu Batteriezellenelementen funktionieren. Zudem lässt sich ein solcher Sensor flexibel an die geometrischen Begebenheiten in der Batteriezelle anpassen. Ein solcher Sensor ist ferner sehr sensitiv zu einem magnetischen Feld und kann bereits minimale Abweichungen vom Normalfall zuverlässig detektieren. Ein Sensor in Form einer Rogowskispule ist außerdem vorteilhaft, weil er unabhängig von magnetisch aktiven Materialien arbeitet.

Die Erfindung ermöglicht somit eine Fehlererkennung bei Stromfluss während des Betriebs der Batteriezelle (Laden / Entladen der Batterie) sowie im Ruhezustand der Batterie. Sofern erforderlich, kann ein für die Detektion geeigneter Entladestrom auch in Ruhephasen der Batterie in der Batteriezelle erzeugt werden, z.B. durch eine steuerbare Entladeschaltung. Neben der Zellüberwachung während des Betriebes der Zelle als Energiespeicher in einem Batteriesystem ist auch ein Einsatz des Verfahrens zur Zellfehlerprüfung nach der Fertigung, während Transport oder Lagerung möglich.

Die obige Beschreibung erfolgte für zwei möglichst identische Batteriezellenelemente, z.B. gleichartig ausgeführte Jelly Rolls. Realisierungen der Detektionsmethoden sind auch für größere Anzahl von Batteriezellenelementen und / oder nicht gleichartige Ausführungen der Batteriezellenelemente möglich, z.B. bei nicht gleich großen Jelly Rolls durch Skalieren der Windungszahl der Rogowskispule oder durch veränderte Sensorplatzierung des Hallsensors.

Ferner wird die erfindungsgemäße Aufgabe durch eine Batterie, insbesondere für Elektromobilitätsanwendungen, mit einer Batteriezelle, die oben beschrieben ist, gelöst. Dabei kann es sich erfindungsgemäß insbesondere um eine Hoch-Energie-Lithium-(lonen-) Batterie handeln. Die Batterie kann vorteilhafterweise in einem, insbesondere prismatischen, Gehäuse angeordnet sein, in welchem mindestens eine Batteriezelle, die oben beschrieben ist, angeordnet sein kann.

Weiterhin wird die erfindungsgemäße Aufgabe durch ein Kraftfahrzeug mit einer Batterie, wie zuvor beschrieben, gelöst.

Weitere, die Erfindung verbessernde Maßnahmen werden nachstehend mit der Beschreibung der bevorzugten Ausführungsbeispiele der Erfindung anhand der Figuren näher dargestellt.

Es zeigen:
Fig. 1a ein Beispiel einer herkömmlichen prismatischen Batteriezelle mit zwei Batteriezellenelementen in einem Gehäuse,
Fig. 1b ein Beispiel von zwei Batteriezellenelementen, welche über einen gemeinsamen Stromkollektor elektrisch verbunden sind,
Fig. 2a schematische Darstellung von zwei verschalteten Batteriezellenelementen und deren Entladestrom,
Fig. 2b einfache Ersatzschaltung für die Batteriezellenelemente der Figur 2a,
Fig. 3 ein Ausführungsbeispiel einer erfindungsgemäßen Batteriezelle mit einem integrierten Sensor zwischen zwei Stromkollektoren,
Fig. 4a ein weiteres Ausführungsbeispiel der erfindungsgemäßen Batteriezelle mit einem integrierten Sensor in einem Zellterminal,
Fig. 4b Ansicht von unten auf das Zellterminal gemäß der Figur 4a,
Fig. 5 ein weiteres Ausführungsbeispiel der erfindungsgemäßen Batteriezelle mit einem integrierten Sensor zwischen zwei Batteriezellenelementen, und
Fig. 6 ein weiteres Ausführungsbeispiel der erfindungsgemäßen Batteriezelle mit einem Sensor in Form einer Rogowskispule.

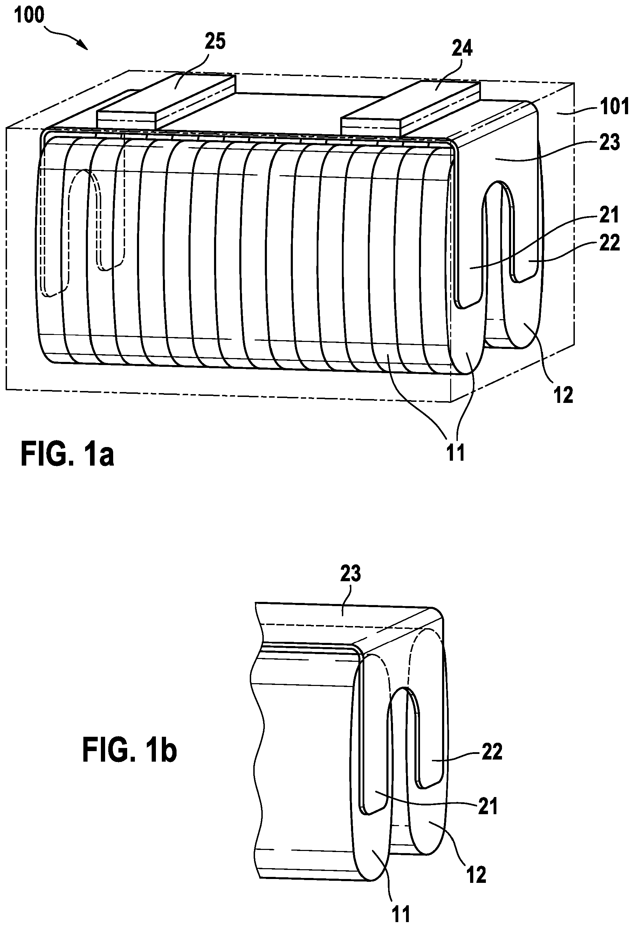

In den Figuren 1a und 1b ist eine Batteriezelle 100 gezeigt, die ihre Anwendung als ein Modulbaustein in Batterien in Kraftfahrzeugen mit einem vollelektrischen Antrieb oder mit einem elektrisch unterstützten Antrieb findet. Innerhalb einer Batterie werden solche Batteriezellen 100 in Reihe geschaltet, um gewünschte elektrische Spannung bereitzustellen. Die Batteriezelle 100 umfasst dabei mehrere Batteriezellenelemente 11, 12, die parallel verschaltet werden, wobei in den Figuren 1a und 1b aus Einfachheitsgründen zwei Batteriezellenelemente 11, 12 gezeigt sind. Solche Batteriezelle 100 kann mit einer Sensorik zur Zellüberwachung verbunden werden, die in bekannten Batterien einfache Steueraktionen ausführen kann, wie z. B. das vollständige Abschalten der Batterie im Fehlerfall einer Batteriezelle 100.

Batteriezellen 100 für Elektromobilitätanwendungen sind häufig elektrochemische Batteriezellen 100, in einer typischen Ausführungsform in einem prismatischen Gehäuse 101, beispielsweise aus Aluminiumlegierungen oder Edelstahl, wie es in der Figur 1a dargestellt ist. Derzeitig werden hierzu üblicherweise Li-Ionen-Batteriezellen verwendet. Die Batteriezellenelemente 11, 12 bestehen dabei aus einer flächigen Anordnung mehrerer Lagen von Trägermaterialien und chemischen Substanzen, welche durch elektrochemische Reaktionen eine elektrische Energiequelle erzeugen. Diese unterschiedlichen Lagen werden in flachen Strukturen übereinander platziert und anschließend in kompakte geometrische Formen gebracht, beispielsweise in flache Wickel, in sogenannte Jelly Rolls, aufgewickelt, oder in sogenannte Zellstapel aufgestapelt. Solche Wickel oder Stapel bilden dabei die Batteriezellenelemente 11, 12. Jedes der Batteriezellenelemente 11, 12 wird dabei jeweils an einen Stromkollektor 21, 22 angeschlossen, wobei die Stromkollektoren 21, 22 aus einem elektrisch leitendem Material ausgebildet sind. Die Stromkollektoren 21, 22 werden wiederum mit einem gemeinsamen Stromkollektor 23 verbunden, wie es in der Figur 1b gezeigt ist. Zum Spannungsabgriff wird die Batteriezelle 100 mit zwei Zellterminals 24, 25 versehen, die als eine Kathode und eine Anode, also als Elektroden der Batteriezelle 100 dienen können.

In der Batteriezelle 100 bzw. in den Batteriezellenelementen 11, 12 können jedoch Fehler auftreten, beispielsweise wenn ein metallischer Partikel einen Separator des Batteriezellenelementes 11, 12 durchdringt, so dass elektrischer Strom unkontrolliert durch die Lagen des Batteriezellenelementes 11, 12 hindurch fließt und einen Kurzschluss in der Batteriezelle 100 verursacht. Ein weiteres Beispiel eines Fehlerfalls in der Batteriezelle 100 ist ein Körperschluss zwischen einem der Batteriezellenelemente 11, 12 und dem elektrisch leitfähigem Gehäuse 101, was bei einem metallischen Gehäuse 101 zu einem Kurzschluss mit anliegenden Elementen führen kann. In einem Fehlerfall können sich einzelne Batteriezellenelemente 11, 12 stark erwärmen, wobei beim Überschreiten einer kritischen Zelltemperatur eine selbst erhaltende exotherme Reaktion in der Batteriezelle 100 ausgelöst werden kann (thermal runaway) und als Folge es sogar zum Zellbrand und zur Zellexplosion kommen kann.

Um diese Gefahren zu vermeiden, die gravierend für Personen, Sachwerte und die Umwelt sein können, müssen solche Fehler frühzeitig erkannt werden, insbesondere bei Batteriezellen 100 für Elektromobilitätsanwendungen, welche oft eine hohe Leistung und hohe gespeicherte Energie in sich tragen.

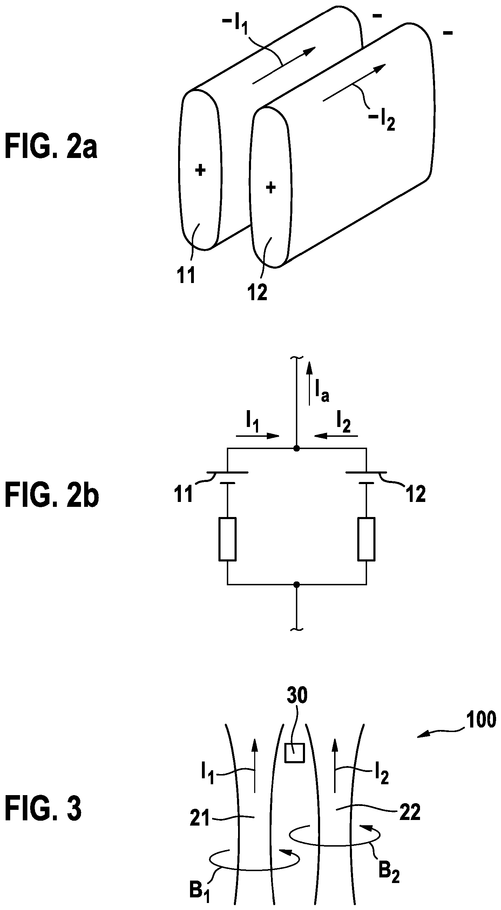

Die Figur 2a zeigt schematisch, wie sich die Teilströme I1 und I2 durch die Batteriezellenelemente 11, 12 verteilen. Die Figur 2b zeigt dabei eine einfache Ersatzschaltung für die Batteriezellenelemente 11, 12, die über elektrische Leitungen, welche als Äquivalente für die Stromkollektoren 21, 22 und für den gemeinsamen Stromkollektor 23 dargestellt werden, miteinander verbunden werden. Bei baugleichen Batteriezellenelementen 11, 12 mit ähnlichem Alterungs- und Ladezustand, was im Normalfall innerhalb einer Batteriezelle 100 zu erwarten ist, kann ungefähr von gleich großen Teilströmen I1, I2 ausgegangen werden, sofern kein Zellfehler vorliegt.

Die Figuren 3, 4b, 5 und 6 zeigen, wie die elektrische Teilströme I1, I2 in Batteriezellenelementen 11, 12 magnetische Felder B1, B2 induzieren. Magnetfeldlinien B1, B2 und die Teilströme I1, I2 sind dabei mit Pfeilen dargestellt. Gleich starke Teilströme I1, I2 sollen gleich starke aber gegensätzlich ausgerichtete Magnetfelder B1= - B2 zwischen den Batteriezellenelementen 11, 12 induzieren, die sich im Normalfall kompensieren (B1+B2=0). Bei Auftreten eines internen Zellfehlers, z. B. durch einen Kurz- oder Körperschluss in einem der Batteriezellenelemente 11, 12, d. h. in einem Fehlerfall der Batteriezelle 100, verteilt sich der durch die Batteriezelle 100 fließende Gesamtstrom I ungleichmäßig (I1≠I2). Ungleiche Teilströme I1, I2 induzieren ungleiche magnetische Felder B1, B2 zwischen den Batteriezellenelementen 11, 12. In diesem Fall ist das resultierende Gesamtfeld ungleich Null (B1+B2≠0). Im Fehlerfall der Batteriezelle 100 ist deswegen ein Magnetfeld B1+B2 zwischen den Batteriezellenelementen 11, 12 messbar (B1+B2≠0). Die Erfindung nutzt vorteilhafterweise diesen Effekt aus, um den Fehlerfall in der Batteriezelle 100 rechtzeitig zu detektieren. Erfindungsgemäß kann dabei ein Sensor 30, insbesondere ein Magnetfeldsensor 30, in der Batteriezelle 100 integriert sein, um das Magnetfeld B1+B2 zwischen den Batteriezellenelementen 11, 12 zu erfassen. Eine Veränderung des Ausgangssignals vom Sensor 30 ist dabei erfindungsgemäß ein direktes Anzeichen für einen Zellfehler, welcher somit mit Hilfe der Erfindung zuverlässig und ohne Zeitverlust erkannt wird.

Der Erfindungsgedanke besteht dabei darin, dass im Fehlerfall der Batteriezelle 100 der Sensor 30 eine detektierbare Veränderung des Ausgangssignals generiert, wobei im Normalfall der Sensor 30 kein Signal oder ein näherungsweise konstantes, bekanntes Signal bereitstellt. Ein Fehlerfall in der Batteriezelle 100 kann somit frühzeitig, insbesondere unmittelbar nach seinem Auftreten erkannt werden. Die negativen Auswirkungen und Folgen auf Personen, Sachwerte und die Umwelt im Fehlerfall der Batteriezelle 100 können mithin vermieden werden, indem notwendige Maßnahmen, wie beispielsweise Abschalten der Batteriezelle 100, Isolieren des fehlerhaften Batteriezellenelementes 11, 12 oder dergleichen, rechtzeitig eingeleitet werden.

Die Figuren 3 bis 5 zeigen dabei mehrere Ausführungsbeispiele der Erfindung, gemäß welcher der Sensor 30 als ein Magnetfeldsensor 30, beispielsweise ein Hallsensor, ausgebildet und an unterschiedlichen Stellen in der Batteriezelle 100 angeordnet sein kann.

Die Figur 3 zeigt dabei ein Ausführungsbeispiel der Erfindung, gemäß welches der Sensor 30 zwischen den Stromkollektoren 21, 22 angeordnet ist. In diesem Fall ist der Sensor 30, beispielsweise der Hallsensor, so zwischen die Stromkollektoren 21, 22 platziert, dass sich die durch die Teilströme I1 und I2 hervorgerufenen Magnetfelder B1, B2 an der Position des Sensors 30 näherungsweise kompensieren, wenn die Teilströme I1, I2 gleich groß sind (I1=I2). Wie oben erläutert, ist der Unterschied zwischen den Teilströmen I1, I2 im Normalfall, d. h. ohne Zellfehler, näherungsweise Null oder kann näherungsweise als zeitlich konstanter, bekannter Wert angenommen werden. Bezüglich dieses Wertes kann der Sensor 30 kalibriert werden, um nur bei einer Abweichung davon ein Ausgangssignal auszugeben. Bei Auftreten von Zellfehlern ergibt sich ein Unterschied der Teilströme I1, I2 und ein von Null verschiedenes Gesamtmagnetfeld B1+ B2 an der Position des Sensors 30 oder als ein vom Normalzustand abweichendes Gesamtmagnetfeld B1+ B2. In diesem Fall gibt der Sensor 30 eine detektierbare Veränderung des Ausgangssignals oder ein von Null abweichendes Ausgangssignal aus. Dieses Ausgangssignal kann somit direkt zur Fehlerdetektion verwendet werden. Der Vorteil der Erfindung liegt dabei darin, dass der Sensor 30 einfach ausgebildet sein kann und keinen elektrischen Kontakt zu den Batteriezellenelementen 11, 12 benötigt. Hierzu kann der Sensor 30 von außen angebracht werden, ohne in die Batteriezellenelemente 11, 12 einzugreifen. Dabei kann der Sensor 30 am bzw. im Gehäuse 101 der Batteriezelle 100 befestigt werden, beispielsweise auf einer isolierenden Unterlage, um die Messung des Magnetfeldes B1, B2 durch das elektrisch leitfähige Gehäuse 101 nicht zu beeinträchtigen.

Ein besonderer Vorteil der Erfindung besteht ferner darin, dass der Sensor 30 an verschiedenen Stellen in der Batteriezelle 100 angeordnet werden kann, um das ungleichmäßige Magnetfeld B1, B2 zwischen den Batteriezellenelementen 11, 12 im Fehlerfall der Batteriezelle 100 zu sensieren. Die erfindungsgemäße Batteriezelle 100 kann somit vorteilhafterweise flexibel ausgestaltet werden.

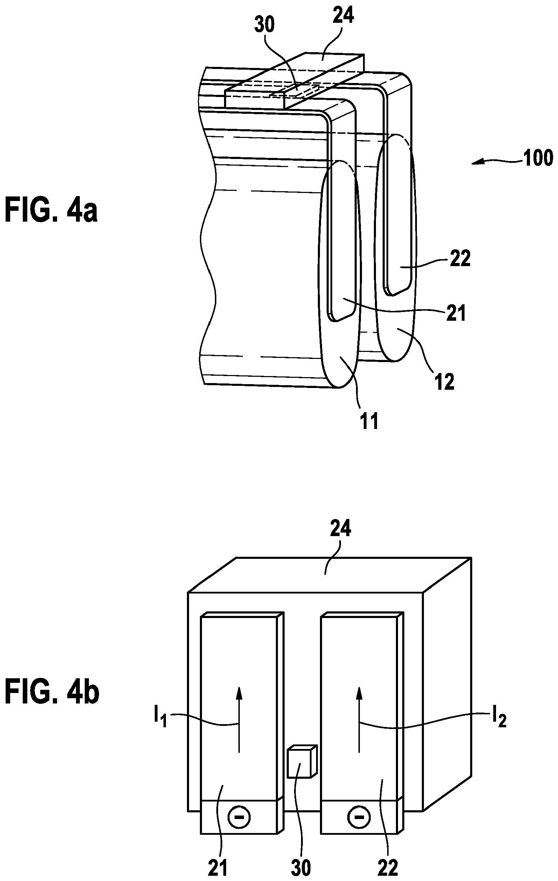

Die Figuren 4a und 4b zeigen dabei ein weiteres Ausführungsbeispiel der Erfindung, gemäß welchem der Sensor 30 in einem der Zellterminals 24 integriert sein kann. In diesem Fall ist der Magnetfeldsensor, z. B. der Hallsensor, so als Bestandteil des Zellterminals 24 zwischen individuell ausgeführten Anschlüssen der Stromkollektoren 21, 22 an das Zellterminal 24 platziert, dass sich die durch die Teilströme I1 und I2 hervorgerufenen Magnetfelder B1, B2 an der Position des Sensors 30 näherungsweise kompensieren, wenn die Teilströme I1, I2 gleich groß sind (I1=I2). Auch hier ist der Unterschied zwischen den Teilströmen I1, I2 ohne Zellfehler näherungsweise Null oder kann näherungsweise als zeitlich konstanter, bekannter Wert angenommen werden. Bei Auftreten von Zellfehlern sind die Teilströme I1, I2 ungleich, wodurch ein von Null oder vom Normalzustand abweichendes Gesamtmagnetfeld B1+B2 an der Sensorposition messbar ist, welches vom Sensor als vom Normalzustand abweichendes Ausgangssignal ausgegeben wird. Diese Veränderung des Ausgangssignals kann direkt zur Fehlerdetektion verwendet werden. Dabei kann der Sensor 30 einfach, sogar in vorhandenen Batteriezellen 100 integriert werden. Hierzu müsste nur das Zellterminal 24 aufgerüstet werden, wie es in der Figur 4b gezeigt ist. Hierbei kann der Sensor 30 von außerhalb der Batteriezelle 100 am Zellterminal 24 befestigt werden. Ein Eindringen in das Innere der Batteriezelle 100 ist somit gar nicht nötig. Mithin können gleichzeitig weitere Vorteile der Erfindung erreicht werden, wie die kontaktlose Anordnung des Sensors 30 bezüglich der Batteriezellenelemente 11, 12 sowie die Vereinfachung des Aufbaus der Batteriezelle 100.

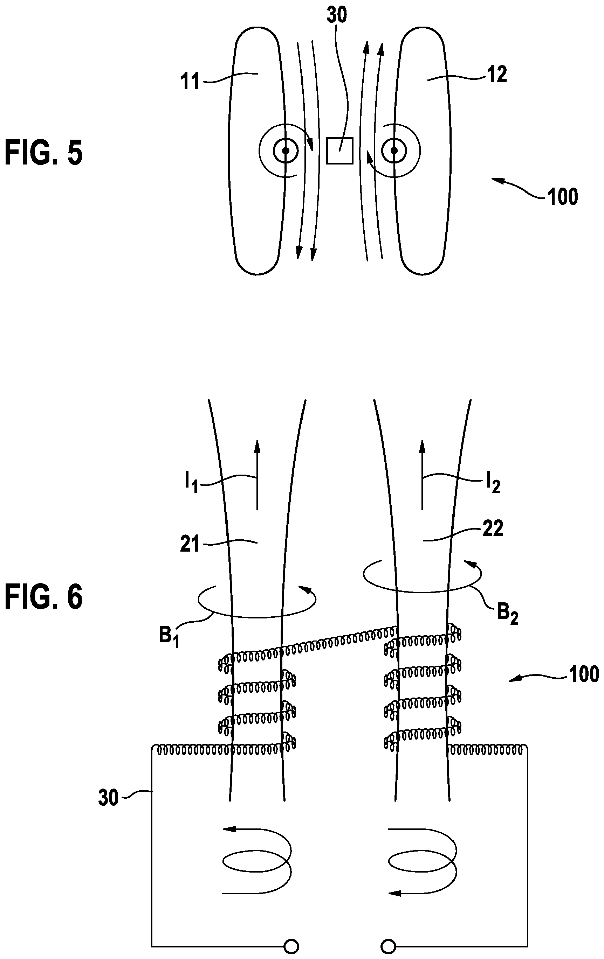

Die Figur 5 zeigt dabei ein noch weiteres Ausführungsbeispiel der Erfindung, gemäß welches der Sensor 30 zwischen den Batteriezellenelementen 11, 12 angeordnet ist. In diesem Fall ist der Magnetfeldsensor, z. B. der Hallsensor, derart direkt zwischen die Batteriezellenelemente 11, 12, beispielsweise in Form von Jelly Rolls, platziert, dass sich die durch die Teilströme I1 und I2 hervorgerufenen Magnetfelder B1, B2 an der Position des Sensors 30 im Normalfall näherungsweise kompensieren. Anders als in den oben erläuterten Ausführungsbeispielen der Erfindung gemäß der Figur 3 und der Figuren 4a, 4b entstehen die Magnetfelder in diesem Fall nicht durch Stromfluss in den Stromkollektoren 21, 22, sondern durch Stromfluss in elektrisch leitenden Lagen der Jelly Rolls. Auch hier ist im Normalfall, d. h. ohne Zellfehler, das induzierte Gesamtmagnetfeld B1, B1 an der Sensorposition näherungsweise Null, oder kann näherungsweise als ein zeitlich konstanter, bekannter Wert angenommen werden. Im Fehlerfall der Batteriezelle 100 verteilen sich die Teilströme ungleichmäßig und es erscheint ein von Null oder vom Normalwert abweichendes Gesamtmagnetfeld B1, B1 an der Sensorposition, welches durch den Sensor 30 messbar ist. Die Veränderungen dieses Signals können somit direkt zur Fehlerdetektion verwendet werden. Auch gemäß dieses Beispiels benötigt der Sensor 30 keine elektrische Verbindung zu den Batteriezellenelementen 11, 12. Der Sensor 30 ist somit unabhängig vom Stromkreis der Batteriezelle 100. Der Aufbau der Batteriezelle 100 kann daher auch hier einfach ausgestaltet werden.

Des Weiteren zeigt die Figur 6 ein Ausführungsbeispiel der Erfindung, gemäß welches der Sensor 30 als eine spezielle Spule, eine sogenannte Rogowskispule, um die Stromkollektoren 21, 22 ausgebildet ist, wobei der Sensor 30 in der Figur 6 beispielhaft für zwei Stromkollektoren 21, 22 dargestellt ist. In der Rogowskispule induzieren die Magnetfelder B1, B2 der Teilströme I1 und I2 jeweils eine Teilspannung. Die Spulenwindungen werden in der Rogowskispule derart gegenläufig angelegt, dass an den Stromkollektoren der Spule sich eine Gesamtspannung ergibt, wenn die Teilströme I1, I2 unterschiedlich sind. Im Normalfall, wenn die Teilströme I1, I2 gleich groß sind, ergibt sich an den Stromkollektoren der Spule eine Gesamtspannung näherungsweise Null bzw. gleich einem zeitlich konstanten, bekannten Wert. Auch hier kann der Sensor 30 so bezüglich dem Wert kalibriert werden, dass nur im Fehlerfall ein Ausgangssignal generiert wird. Veränderungen dieses Signals können somit direkt zur Fehlerdetektion verwendet werden. Ein solcher Sensor 30 in Form der Rogowskispule kann einfach angelegt und entfernt werden, ohne den Stromkreis der Batteriezelle 100 zu beeinflussen. Der Sensor 30 funktioniert somit auch hier kontaktlos zu Batteriezellenelementen 11,12.

Zusammenfassend lässt sich feststellen, dass sich der erfindungsgemäße Sensor 30 auf unterschiedliche Weise realisieren und flexibel an die geometrischen Begebenheiten in der Batteriezelle 100 anpassen lässt. Der erfindungsgemäße Sensor 30, sowohl in Form des Hallsensors als auch der Rogowskispule, ist sehr sensitiv und kann bereits minimale Abweichungen vom Normalfall zuverlässig detektieren. Außerdem kann der erfindungsgemäße Sensor 30, in Form des Hallsensors oder der Rogowskispule, unabhängig von magnetisch aktiven Materialien arbeiten, was den Sensor 30 günstig in Herstellung macht.

Mit Hilfe der Erfindung lässt sich die Fehlerdetektion einfach, schnell und zuverlässig realisieren. Außerdem kann der erfindungsgemäße Sensor 30 nicht nur einfach, sondern auch auf unterschiedlichste Weise konstruiert werden sowie an verschiedenen Stellen in der Batteriezelle 100 angeordnet werden. Vorteilhafterweise erfordert der erfindungsgemäße Sensor 30 keine nachteiligen Modifikationen der hochstromführenden Teile der Batteriezelle 100, wie z. B. Einbringen von Shuntstrukturen zur Strommessung in Stromkollektoren und Einsetzen von komplizierten Auswertelektroniken in der Batteriezelle 100, oder das Anordnen mehrerer Batteriezellen in einer Parallelschaltung.

## Patentansprüche

1. Batteriezelle (100) mit
mindestens einem ersten Batteriezellenelement (11),
und einem zweiten Batteriezellenelement (12), welche über mindestens einen Stromkollektor (21, 22, 23) elektrisch mit einander verbunden sind,
und einem Sensor (30) zum Überwachen mindestens eines Parameters (B) der Batteriezelle (100),
**dadurch gekennzeichnet, dass**
der Sensor (30) derart ausgebildet ist, dass ausschließlich im Fehlerfall der Batteriezelle (100) der Sensor (30) eine detektierbare Veränderung eines Ausgangssignals generiert,
wobei die Batteriezelle (100) mindestens ein Zellterminal (24) aufweist, welches als ein elektrischer Kontakt der Batteriezelle (100) dient, wobei der Sensor (30) im Zellterminal (24) integriert ist,.

2. Batteriezelle (100) nach Anspruch 1,
**dadurch gekennzeichnet, dass**
die Batteriezelle eine prismatische Batteriezelle, eine Rundzelle oder dergleichen ist, und dass insbesondere
das Batteriezellenelement ein flaches oder ein rundes Batteriezellenelement, insbesondere eine Jelly Roll oder eine gestapelte Anordnung von Aktivmaterialien, ist.

3. Batteriezelle (100) nach einem der vorhergehenden Ansprüche,
**dadurch gekennzeichnet, dass**
der Parameter (B) der Batteriezelle (100) zumindest das Magnetfeld zwischen den Batteriezellenelementen ist.

4. Batteriezelle (100) nach einem der vorhergehenden Ansprüche,
**dadurch gekennzeichnet, dass**
der Sensor (30) ein Magnetfeldsensor, insbesondere ein Hallsensor, ist.

5. Batteriezelle (100) nach einem der vorhergehenden Ansprüche,
**dadurch gekennzeichnet, dass**
das erste Batteriezellenelement (11) einen ersten Stromkollektor (21) aufweist und das zweite Batteriezellenelement (12) einen zweiten Stromkollektor (22) aufweist, wobei der erste Stromkollektor (21) mit dem zweiten Stromkollektor (22) über einen gemeinsamen Stromkollektor (23) elektrisch verbunden ist, und dass insbesondere der Sensor zwischen dem ersten Stromkollektor (21) und dem zweiten Stromkollektor (22) angeordnet ist.

6. Batteriezelle (100) nach einem der vorhergehenden Ansprüche,
**dadurch gekennzeichnet, dass**
der Sensor (30) zwischen den Batteriezellenelementen (11, 12) angeordnet ist.

7. Batteriezelle (100) nach einem der vorhergehenden Ansprüche,
**dadurch gekennzeichnet, dass**
der Sensor (30) in Form einer Spule, insbesondere einer Rogowskispule, ausgebildet ist.

8. Batterie, insbesondere für Elektromobilitätsanwendungen und/oder Anwendungen in stationärer Energieversorgung, mit einer Batteriezelle (100) nach einem der vorhergehenden Ansprüche.

## Claims

1. Battery cell (100), comprising
at least one first battery cell element (11) and one second battery cell element (12), which are electrically connected to one another via at least one current collector (21, 22, 23),
and a sensor (30) for monitoring at least one parameter (B) of the battery cell (100),
**characterized in that**
the sensor (30) is designed in such a way that the sensor (30) generates a detectable change in an output signal only in the event of a fault of the battery cell (100), wherein the battery cell (100) has at least one cell terminal (24) that serves as an electrical contact of the battery cell (100), wherein the sensor (30) is integrated in the cell terminal (24).

2. Battery cell (100) according to Claim 1,
**characterized in that**
the battery cell is a prismatic battery cell, a round cell or the like, and **in that** the battery cell element is in particular a flat or a round battery cell element, in particular a jelly roll or a stacked arrangement of active materials.

3. Battery cell (100) according to either of the preceding claims,
**characterized in that**
the parameter (B) of the battery cell (100) is at least the magnetic field between the battery cell elements.

4. Battery cell (100) according to one of the preceding claims,
**characterized in that**
the sensor (30) is a magnetic field sensor, in particular a Hall sensor.

5. Battery cell (100) according to one of the preceding claims,
**characterized in that**
the first battery cell element (11) has a first current collector (21) and the second battery cell element (12) has a second current collector (22), wherein the first current collector (21) is electrically connected to the second current collector (22) via a common current collector (23), and **in that** the sensor is in particular arranged between the first current collector (21) and the second current collector (22).

6. Battery cell (100) according to one of the preceding claims,
**characterized in that**
the sensor (30) is arranged between the battery cell elements (11, 12).

7. Battery cell (100) according to one of the preceding claims,
**characterized in that**
the sensor (30) is designed in the form of a coil, in particular a Rogowski coil.

8. Battery, in particular for electromobility applications and/or stationary energy supply applications, comprising a battery cell (100) according to one of the preceding claims.

## Revendications

1. Cellule de batterie (100) comprenant au moins un premier élément de cellule de batterie (11), et un deuxième élément de cellule de batterie (12), lesquels sont reliés électriquement l'un à l'autre par le biais d'au moins un collecteur de courant (21, 22, 23),
et un capteur (30) destiné à surveiller au moins un paramètre (B) de la cellule de batterie (100), **caractérisée en ce que**
le capteur (30) est configuré de telle sorte que le capteur (30) génère une modification détectable d'un signal de sortie exclusivement dans le cas d'un défaut de la cellule de batterie (100),
la cellule de batterie (100) possédant au moins une borne de cellule (24), laquelle sert de contact électrique de la cellule de batterie (100),
le capteur (30) étant intégré dans la borne de cellule (24) .

2. Cellule de batterie (100) selon la revendication 1, **caractérisée en ce que** la cellule de batterie est une cellule de batterie prismatique, une cellule ronde ou similaire, et notamment **en ce que** l'élément de cellule de batterie est un élément de cellule de batterie plat ou rond, notamment une cellule dite en « rouleau suisse » ou un arrangement empilé de matériaux actifs.

3. Cellule de batterie (100) selon l'une des revendications précédentes, **caractérisée en ce que** le paramètre (B) de la cellule de batterie (100) est au moins le champ magnétique entre les éléments de cellule de batterie.

4. Cellule de batterie (100) selon l'une des revendications précédentes, **caractérisée en ce que** le capteur (30) est un capteur de champ magnétique, notamment un capteur à effet Hall.

5. Cellule de batterie (100) selon l'une des revendications précédentes, **caractérisée en ce que** le premier élément de cellule de batterie (11) possède un premier collecteur de courant (21) et le deuxième élément de cellule de batterie (12) possède un deuxième collecteur de courant (22), le premier collecteur de courant (21) étant relié électriquement au deuxième collecteur de courant (22) par le biais d'un collecteur de courant commun (23) et notamment **en ce que** le capteur est disposé entre le premier collecteur de courant (21) et le deuxième collecteur de courant (22).

6. Cellule de batterie (100) selon l'une des revendications précédentes, **caractérisée en ce que** le capteur (30) est disposé entre les éléments de cellule de batterie (11, 12).

7. Cellule de batterie (100) selon l'une des revendications précédentes, **caractérisée en ce que** le capteur (30) est réalisé sous la forme d'une bobine, notamment d'un enroulement de Rogowski.

8. Batterie, notamment pour des applications d'électromobilité et/ou des applications dans l'alimentation en énergie stationnaire, comprenant une cellule de batterie (100) selon l'une des revendications précédentes.
